# EUROPEAN PATENT APPLICATION

(11) **EP 2 647 693 A1**
(43) Date of publication of application: **09.10.2013**
(21) Application number: 11845260.6
(22) Date of filing: 28.11.2011
(51) Int. Cl.: C11D 7/32, C11D 7/08, C11D 7/10, H01L 21/304

(54) **SUBSTRATE CLEANER FOR COPPER WIRING, AND METHOD FOR CLEANING COPPER WIRING SEMICONDUCTOR SUBSTRATE**

(30) Priority: 29.11.2010 JP 2010265807
(71) Applicant: Wako Pure Chemical Industries, Ltd., Osaka-shi Osaka 540-8605 (JP)
(72) Inventor: KAWADA Hiromi, Kawagoe-shi Saitama 350-1101 (JP); SHIRAHATA Satoshi, Kawagoe-shi Saitama 350-1101 (JP); MIZUTA Hironori, Kawagoe-shi Saitama 350-1101 (JP); KAKIZAWA Masahiko, Kawagoe-shi Saitama 350-1101 (JP); SHIRAKI Kazuo, Kawagoe-shi Saitama 350-1101 (JP)
(74) Representative: Hinkelmann, Klaus
(86) International application number: PCT/JP2011/077436
(87) International publication number: WO 2012/073909

(57) **Abstract**

It is an object of the present invention to provide a cleaning agent for a substrate having a copper wiring, which makes possible to sufficiently suppress elution of metal copper, and remove impurities or particles of copper hydroxide (II), copper oxide (II) and the like, generated by the chemical mechanical polishing (CMP) process, in cleaning of a semiconductor substrate after the chemical mechanical polishing (CMP) process, in a manufacturing process of the semiconductor substrate; and a method for cleaning a semiconductor substrate having a copper wiring, characterized by using the relevant substrate cleaner for a copper wiring: and the present invention relates to a cleaning agent for a substrate having a copper wiring consisting of an aqueous solution comprising [I] an amino acid represented by the following general formula [1], and [II] an alkylhydroxylamine; and a method for cleaning a semiconductor substrate having a copper wiring characterized by using the relevant cleaning agent for a substrate having a copper wiring; 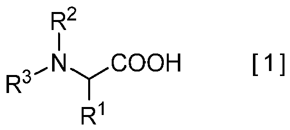 (wherein R¹ represents a hydrogen atom, a carboxymethyl group or a carboxyethyl group; and R² and R³ each independently represents a hydrogen atom or an alkyl group having 1 to 4 carbon atoms, which may have a hydroxyl group, provided that those where R¹ to R³ are all hydrogen atoms are excluded.).

## Description

### TECHNICAL FIELD

The present invention relates to a cleaning agent for a substrate having a copper wiring and a method for cleaning a semiconductor substrate having a copper wiring, characterized by using the cleaning agent, and in more detail, the present invention relates to the cleaning agent for a substrate having a copper wiring to be used in the process for removing residues after performing chemical mechanical polishing (CMP) for a semiconductor substrate having a copper wiring or copper alloy wiring, in the process for forming the semiconductor device on the semiconductor substrate such as a silicon wafer, and a method for cleaning a semiconductor substrate having a copper wiring characterized by using the relevant cleaning agent for a substrate having a copper wiring.

### BACKGROUND ART

In recent years, in a semiconductor manufacturing process, it has been progressed to make an IC or a LSI by higher speed and higher integration, and accompanying with it, a wiring to be used has also been shifting from conventional aluminum to copper (Cu) having high conductivity. Still more, in the case of manufacturing a semiconductor substrate having a multi-layer structure provided with a wiring such as a copper wiring over multi layers, chemical mechanical polishing (CMP) has become essential, which flattens the semiconductor substrate by polishing it physically.

The chemical mechanical polishing (CMP) is a method for flattening the semiconductor substrate provided with a silicon oxidized film or a metal wiring such as a copper wiring, which is a polishing object, using a slurry including abrasive grain (polishing agent) such as silica, alumina. The semiconductor substrate after such a chemical mechanical polishing (CMP) process is contaminated with the abrasive grain (polishing agent) themselves used in the relevant process, or metals included in the slurry, metal impurities derived from the metal wiring of a polishing object, and still more various kinds of particles. If the semiconductor substrate receives contamination by the metal impurities or particles, it gives adverse influence on electrical characteristics of the semiconductor itself, and decreases reliability of a device, therefore, it is necessary to remove the metal impurities or particles from the substrate surface, by cleaning the semiconductor substrate after the chemical mechanical polishing (CMP) process.

On the other hand, a copper wiring or copper alloy wiring to be used in the semiconductor manufacturing process has high metallic activity while having high conductivity as described above, therefore is easily oxidized (corroded) by oxidation action from the outside, which has a problem of causing increase in wiring resistance, or in some cases incurring disconnection or the like. In addition, in the chemical mechanical polishing (CMP) process, there may be the case of increasing wiring resistance or incurring disconnection, by also generation of the copper (copper alloy) residue of the copper wiring or copper alloy wiring which is a polishing object, scratch, or dishing or the like. Accordingly, in the chemical mechanical polishing (CMP) process, there has been performed suppressing of generation of the copper (copper alloy) residue, scratch, or dishing or the like, as well as preventing of corrosion of the copper wiring, by forming a coating film (protection film) including a metal corrosion inhibitor such as BTA, QCA, at the surface of the copper wiring, by adding a metal corrosion inhibitor such as, for example, benzotriazoles, (hereafter there may be the case where benzotriazole is abbreviated as BTA), imidazoles, quinaldic acids (hereafter there may be the case where quinaldic acid is abbreviated as QCA), and quinolinic acids. Such a metal corrosion inhibitor forms a complex with a monovalent copper in the copper wiring or copper alloy wiring of, for example, a copper (I)-benzotriazole coating film (Cu (I)-BTA coating film) or the like; or a complex with a divalent copper in the copper wiring or copper alloy wiring of a copper (II)-quinaldic acid coating film (Cu (II)-QCA coating film) or the like. It has been considered that such a complex is more easily processed as compared with copper itself, therefore by suppressing the copper (copper alloy) residue or protecting the surface of the copper wiring or copper alloy wiring, generation of scratch or dishing is suppressed or corrosion is prevented.

Recently, accompanying with making an IC or a LSI by higher speed and higher integration, it has been required to attain the copper wiring or copper alloy wiring having an ultra fine structure. Accordingly, also in the cleaning process of the semiconductor manufacturing process, further improvement has been required. That is, the cleaning agent used conventionally in the cleaning process after the chemical mechanical polishing (CMP), (for example, PATENT LITERATURE 1 or the like), is difficult to produce a semiconductor substrate having high quality required.

In the case where, for example, the cleaning agent described in PATENT LITERATURE 1, 2 and 3, is used simply as it is, as the cleaning agent after the chemical mechanical polishing (CMP) process of the semiconductor substrate having the copper wiring or copper alloy wiring formed with the coating film of monovalent copper and the metal corrosion inhibitor (metal corrosion inhibition film layer) such as a Cu (I)-BTA coating film, which is formed by a monovalent copper and benzotriazole or a derivative thereof, there are such problems as easy peeling off the coating film such as the Cu (I)-BTA coating film, and being unable to sufficiently suppress elution of metal copper, or having insufficient action of selective removal of Cu (II). In addition, in the cleaning agent as described in PATENT LITERATURE 4, there is no particular problem in the case where the coating film of copper and the metal corrosion inhibitor (metal corrosion inhibition film layer), such as the Cu (I)-BTA coating film, is formed sufficiently, however, in the case where it is not formed sufficiently, there was the case where the copper wiring or copper alloy wiring present at the lower layer was corroded.

In addition, in the case where, for example, the cleaning agent described in PATENT LITERATURE 5 is used simply as it is, as the cleaning agent after the chemical mechanical polishing (CMP) process of the semiconductor substrate having the copper wiring or copper alloy wiring formed with the coating film of divalent copper and the metal corrosion inhibitor, such as a Cu (II)-QCA coating film, which is formed by a divalent copper and quinaldic acid or a derivative thereof, there are problems of making difficult to completely remove the coating film of copper and the metal corrosion inhibitor, such as a Cu (II)-QCA coating film, being impossible to effectively remove the metal impurities or particles, and being impossible to sufficiently suppress elution of the metal copper.

### PRIOR ART LITERATURE

### PATENT LITERATURE

PATENT LITERATURE 1: JP-A-2005-217114
PATENT LITERATURE 2: JP-A-2006-63201
PATENT LITERATURE 3: JP-A-2001-517863
PATENT LITERATURE 4: WO 2005/040325
PATENT LITERATURE 5: JP-A-2002-359223

### DISCLOSURE OF INVENTION

### TECHNICAL PROBLEM

The present invention has been proposed in view of the above situation, and it is an object of the present invention to provide, for example, in the semiconductor substrate manufacturing process, at cleaning the semiconductor substrate after the chemical mechanical polishing (CMP) process, the cleaning agent for a substrate having a copper wiring which does not dissolve the coating film of copper and the metal corrosion inhibitor (metal corrosion inhibition film layer) consisting of the monovalent copper complex, such as the Cu (I)-BTA coating film, as well as being capable of effectively dissolving and removing the coating film of copper and the metal corrosion inhibitor (metal corrosion inhibition film layer) consisting of the divalent copper complex, such as a Cu (II)-QCA coating film, and still more sufficiently suppressing elution of the metal copper, and enabling to remove impurities or particles of copper hydroxide (II), copper oxide (II) and the like, generated by the chemical mechanical polishing (CMP) process, even when formation of the metal corrosion inhibition film layer is insufficient; and the method for cleaning a semiconductor substrate having a copper wiring, characterized by using the relevant cleaning agent for a substrate having a copper wiring.

### TECHNICAL SOLUTION

The present invention is an invention of a cleaning agent for a substrate having a copper wiring consisting of an aqueous solution comprising [I] an amino acid represented by the following general formula [1], and [II] an alkylhydroxylamine;

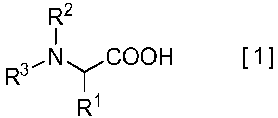

(wherein R¹ represents a hydrogen atom, a carboxymethyl group or a carboxyethyl group; and R² and R³ each independently represents a hydrogen atom or an alkyl group having 1 to 4 carbon atoms, which may have a hydroxyl group, provided that those where R¹ to R³ are all hydrogen atoms are excluded.).

In addition, the present invention is an invention of a method for cleaning a semiconductor substrate having a copper wiring, characterized by using the cleaning agent for a substrate having a copper wiring consisting of an aqueous solution comprising [I] the amino acid represented by the above general formula [1], and [II] the alkylhydroxylamine.

### ADVANTAGEOUS EFFECTS

The cleaning agent for a substrate having a copper wiring of the present invention is the one to be used in a cleaning process etc. of the substrate surface formed with the copper wiring or copper alloy wiring, for example, after the chemical mechanical polishing (CMP) process, which does not dissolve the coating film of copper and the metal corrosion inhibitor (metal corrosion inhibition film layer) consisting of the monovalent copper complex, such as the Cu (I)-BTA coating film, and is capable of effectively dissolving and removing the coating film of copper and the metal corrosion inhibitor (metal corrosion inhibition film layer) consisting of the divalent copper complex such as a Cu (II)-QCA coating film, and still more sufficiently suppressing elution of the metal copper, and removing impurities or particles of copper hydroxide (II), copper oxide (II) and the like, generated by the chemical mechanical polishing (CMP) process, even when formation of the metal corrosion inhibition film layer is insufficient. Use of the cleaning agent for a substrate having a copper wiring of the present invention is capable of obtaining a substrate, where copper hydroxide (II) and/or copper oxide (II) are removed, which are adhered and remained at the substrate surface after the chemical mechanical polishing (CMP) process.

In addition, the method for cleaning a semiconductor substrate having a copper wiring of the present invention is an effective cleaning method of the semiconductor substrate or the like, for example, after the chemical mechanical polishing (CMP) process, and by using the cleaning agent for a substrate having a copper wiring of the present invention, it becomes possible to effectively clean the semiconductor substrate.

That is, the present inventors have intensively studied a way to attain the above-described object and found that only the specific amino acids represented by the above general formula [1], among various amino acids, does not dissolve the monovalent metal corrosion inhibition film layer, such as the Cu (I)-BTA coating film, and can effectively dissolve and remove the divalent metal corrosion inhibition film layer such as a Cu (II)-QCA coating film, and still more can sufficiently remove copper hydroxide (II) and/or copper oxide (II), without corroding metal copper, even when formation of the metal corrosion inhibition film layer is insufficient. Still more, the present inventors have discovered that only alkylhydroxylamine, which is a specific reducing agent, does not inhibit elution and removal action of copper hydroxide (II) and/or copper oxide (II) of the specific amino acids represented by the above general formula [1], suppresses corrosion of metal copper to copper oxide (II), and is capable of strengthening bonding of the monovalent copper complex to be formed by copper and the metal corrosion inhibitor, such as Cu (I)-BTA coating film, with the copper wiring or copper alloy wiring. And, the present inventors have found that the above effect of the present invention can be obtained firstly by combined use of these specific amino acids represented by the above general formula [1] and alkylhydroxylamine, and have thus completed the present invention.

### DESCRIPTION OF EMBODIMENTS

### -The cleaning agent for a substrate having a copper wiring of the present invention-

The cleaning agent for a substrate having a copper wiring of the present invention is the one consisting of an aqueous solution comprising [I] the amino acids represented by the following general formula [1], and [II] an alkylhydroxylamine;

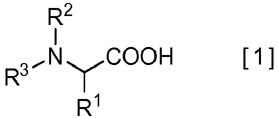

(wherein R¹ represents a hydrogen atom, a carboxymethyl group or a carboxyethyl group; and R² and R³ each independently represents a hydrogen atom or an alkyl group having 1 to 4 carbon atoms, which may have a hydroxyl group, provided that those where R¹ to R³ are all hydrogen atoms are excluded.).

In the amino acids represented by the general formula [1], as the alkyl group, represented by R² and R³, having 1 to 4 carbon atoms, which may have a hydroxyl group, there is included specifically, for example, a linear, branched or cyclic alkyl group such as a methyl group, an ethyl group, a n-propyl group, an isopropyl group, a n-butyl group, an isobutyl group, a sec-butyl group, a tert-butyl group, and a cyclobutyl group; a linear, branched or cyclic hydroxyalkyl group such as a 1-hydroxyethyl group, a 2-hydroxyethyl group, a 2-hydroxy-n-propyl group, a 3-hydroxy-n-propyl group, a 2,3-dihydroxy-n-propyl group, a 2-hydroxyisopropyl group, a 2-hydroxy-n-butyl group, a 3-hydroxy-n-butyl group, a 4-hydroxy-n-butyl group, a 2,3-dihydroxy-n-butyl group, a 2,4-dihydroxy-n-butyl group, a 3,4-dihydroxy-n-butyl group, a 2,3,4-trihydroxy-n-butyl group, a 2-hydroxy-sec-butyl group, a 3-hydroxy-sec-butyl group, a 4-hydroxy-sec-butyl group, a 2,3-dihydroxy-sec-butyl group, a 2,4-dihydroxy-sec-butyl group, a 3,4-dihydroxy-sec-butyl group, a 2-hydroxy-2-methyl-n-propyl group, a 3-hydroxy-2-methyl-n-propyl group, a 2,3-dihydroxy-2-methyl-n-propyl group, a 3-hydroxy-2-hydroxymethyl-n-propyl group, a 2,3-dihydroxy-2-hydroxymethyl-n-propyl group, a trihydroxy-tert-butyl group, and among them, a methyl group, a 2-hydroxyethyl group, and a trihydroxy-tert-butyl group are preferable.

As a specific example of the amino acids represented by the general formula [1], there is included amino acids of N-alkylglycine such as, for example, N-methylglycine (sarcosine), N-ethylglycine, N-n-propylglycine, N-isopropylglycine, N-n-butylglycine, N-isobutylglycine, N-sec-butylglycine, N-tert-butylglycine, N-cyclobutylglycine; N,N-dialkylglycine such as, for example, N,N-dimethylglycine, N,N-diethylglycine, N,N-di-n-propylglycine, N,N-diisopropylglycine, N,N-di-n-butylglycine, N,N-diisobutylglycine, N,N-di-sec-butylglycine, N,N-di-tert-butylglycine, N,N-dicyclobutylglycine, N,N-ethylmethylglycine; N-alkyl or N,N-di(bis)alkylglycine having a hydroxyl group, such as, for example, N-(2-hydroxyethyl)glycine, N,N-bis(2-hydroxyethyl)glycine, N-(3-hydroxy-n-propyl)glycine, N,N-bis(3-hydroxy-n-propyl)glycine, N-(4-hydroxy-n-butyl)glycine, N,N-bis(4-hydroxy-n-butyl)glycine, N-[tris(hydroxymethyl)methyl]glycine; an acidic amino acid such as, for example, aspartic acid, N-methylaspartic acid, N,N-dimethylaspartic acid, glutamic acid, N-methylglutamic acid, N,N-dimethylglutamic acid, and the like. It should be noted that as these amino acids represented by the general formula [1], it is enough to use a commercial one, or the one synthesized, as appropriate, by a known method.

Among [I] the amino acids represented by the general formula [1] in the cleaning agent for a substrate having a copper wiring of the present invention, the amino acids represented by the following general formula [2] and the general formula [3] are preferable;

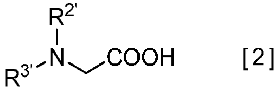

(wherein R^{2'} and R^{3'} each independently represents a hydrogen atom or an alkyl group having 1 to 4 carbon atoms, which may have a hydroxyl group, provided that those where R^{1'} to R^{3'} are all hydrogen atoms are excluded.),

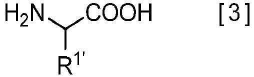

(wherein R^{1'} represents a carboxymethyl group or a carboxyethyl group.).

In the amino acids represented by the general formula [2], as the alkyl group having 1 to 4 carbon atoms, which may have a hydroxyl group represented by R^{2'} and R^{3'}, a similar one to the alkyl group having 1 to 4 carbon atoms, which may have a hydroxyl group, represented by R² and R³ in the above general formula [1], is included.

As a specific example of the amino acids represented by the general formula [2], there is included amino acids of N-alkylglycine such as, for example, N-methylglycine (sarcosine), N-ethylglycine, N-n-propylglycine, N-isopropylglycine, N-n-butylglycine, N-isobutylglycine, N-sec-butylglycine, N-tert-butylglycine, N-cyclobutylglycine; N,N-dialkylglycine such as, for example, N,N-dimethylglycine, N,N-diethylglycine, N,N-di-n-propylglycine, N,N-diisopropylglycine, N,N-di-n-butylglycine, N,N-diisobutylglycine, N,N-di-sec-butylglycine, N,N-di-tert-butylglycine, N,N-dicyclobutylglycine, N,N-ethylmethylglycine; N-alkyl or N,N-di(bis)alkylglycine having a hydroxyl group, such as, for example, N-(2-hydroxyethyl)glycine, N,N-bis(2-hydroxyethyl)glycine, N-(3-hydroxy-n-propyl)glycine, N,N-bis(3-hydroxy-n-propyl)glycine, N-(4-hydroxy-n-butyl)glycine, N,N-bis(4-hydroxy-n-butyl)glycine, N-[tris(hydroxymethyl)methyl]glycine, or the like.

As a specific example of the amino acids represented by the general formula [3], there is included, for example, amino acids such as aspartic acid and glutamic acid.

Among the amino acids represented by the general formula [2] and the general formula [3], N-methylglycine (sarcosine), N,N-bis(2-hydroxyethyl)glycine, N-[tris(hydroxymethyl)methyl]glycine, aspartic acid, and glutamic acid are more preferable. Such amino acid has particularly high effect in view of effectively dissolving and removing a copper oxide such as copper hydroxide (II), copper oxide (II), without dissolving metal copper, as much as possible, as compared with other amino acids relevant to the present invention. The amino acids represented by the general formula [2] and the general formula [3] are particularly effective in view of not dissolving the Cu (I)-BTA complex formed at the copper wiring surface, even when it is used in the semiconductor substrate having the copper wiring (formed with the Cu (I)-BTA coating film) coated with the copper (I)-benzotriazole complex (Cu(I)-BTA complex) formed by monovalent copper and benzotriazole or a derivative thereof.

In the case of using [I] the amino acids represented by the general formula [1] to the semiconductor substrate having the copper wiring (formed with the Cu (II)-QCA coating film) coated with the copper (II)-quinaldic acid complex (Cu (II)-QCA complex) formed by divalent copper and quinaldic acid or a derivative thereof, it is desirable to use at least any of N,N-bis(2-hydroxyethyl)glycine or N-[tris(hydroxymethyl)methyl]glycine. That is, N,N-bis(2-hydroxyethyl)glycine and N-[tris(hydroxymethyl)methyl]glycine are superior amino acids in view of being capable of not only effectively dissolving and removing a copper oxide such as copper hydroxide (II), copper oxide (II), but also effectively dissolving and removing the Cu (II)-QCA complex formed at the copper wiring surface, without dissolving metal copper as much as possible.

[1] the amino acids represented by the general formula [1] can be used alone or in combination of two or more kinds, however, in the case of using the amino acid in the semiconductor substrate having the copper wiring (formed with the Cu (II)-QCA coating film) coated with the copper (II)-quinaldic acid complex (Cu (II)-QCA complex) formed by divalent copper and quinaldic acid or a derivative thereof, it is preferable to use any of N,N-bis(2-hydroxyethyl)glycine or N-[tris(hydroxymethyl)methyl]glycine and other amino acids represented by the general formula [1], in combination. As such a combination, there is included, for example, a combination of N,N-bis(2-hydroxyethyl)glycine and N-methylglycine (sarcosine); for example, a combination of N,N-bis(2-hydroxyethyl)glycine and glutamic acid, or the like. In addition, weight ratio, in the case of using any of N,N-bis(2-hydroxyethyl)glycine or N-[tris(hydroxymethyl)methyl]glycine and other amino acids represented by the general formula [1], in combination, in view of lytic action of the Cu (II)-QCA complex and free QCA, and corrosion action of the copper wiring, for example, as weight ratio of N,N-bis(2-hydroxyethyl)glycine and other amino acids represented by the general formula [1] (N,N-bis(2-hydroxyethyl)glycine: other amino acids), is usually 99: 1 to 30: 70, preferably 90: 10 to 60: 40, and more preferably 85: 15 to 70: 30.

As the [II] alkylhydroxyl amine in the cleaning agent for a substrate having a copper wiring of the present invention, for example, the one represented by the following general formula [4] is included;

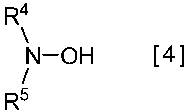

(wherein R⁴ represents an alkyl group having 1 to 6 carbon atoms, and R⁵ represents a hydrogen atom or an alkyl group having 1 to 6 carbon atoms.).

In the alkylhydroxyl amine represented by the general formula [4], as the alkyl group having 1 to 6 carbon atoms, represented by R⁴ and R⁵, there is included specifically, for example, a linear, branched or cyclic alkyl group having 1 to 6 carbon atoms such as a methyl group, an ethyl group, a n-propyl group, an isopropyl group, a n-butyl group, an isobutyl group, a sec-butyl group, a tert-butyl group, a cyclobutyl group, a n-pentyl group, an isopentyl group, a sec-pentyl group, a tert-pentyl group, a neopentyl group, a 2-methylbutyl group, a 1,2-dimethylpropyl group, a 1-ethylpropyl group, a cyclopentyl group, a n-hexyl group, an isohexyl group, a sec-hexyl group, a tert-hexyl group, a neohexyl group, a 2-methylpentyl group, a 1,2-dimethylbutyl group, a 2,3-dimethylbutyl group, a 1-ethylbutyl group, or a cyclohexyl group, and among them, an ethyl group and a n-propyl group are preferable.

As a specific example of the alkylhydroxyl amine represented by the general formula [4], there is included, for example, N-methylhydroxylamine, N,N-dimethylhydroxylamine, N-ethylhydroxylamine, N,N-diethylhydroxylamine, N-n-propylhydroxylamine, N,N-di-n-propylhydroxylamine, N-isopropylhydroxylamine, N,N-diisopropylhydroxylamine, N-n-butylhydroxylamine, N,N-di-n-butylhydroxylamine, N-isobutylhydroxylamine, N,N-diisobutylhydroxylamine, N-sec-butylhydroxylamine, N,N-di-sec-butylhydroxylamine, N-tert-butylhydroxylamine, N,N-di-tert-butylhydroxylamine, N-cyclobutylhydroxylamine, N,N-dicyclobutylhydroxylamine, N-n-pentylhydroxylamine, N,N-di-n-pentylhydroxylamine, N-isopentylhydroxylamine, N,N-diisopentylhydroxylamine, N-sec-pentylhydroxylamine, N,N-di-sec-pentylhydroxylamine, N-tert-pentylhydroxylamine, N,N-di-tert-pentylhydroxylamine, N-neopentylhydroxylamine, N,N-dineopentylhydroxylamine, N-(2-methylbutyl)hydroxylamine, N,N-bis(2-methylbutyl)hydroxylamine, N-(1,2-dimethylpropyl)hydroxylamine, N,N-bis(1,2-dimethylpropyl)hydroxylamine, N-(1-ethylpropyl)hydroxylamine, N,N-bis(1-ethylpropyl)hydroxylamine, N-cyclopentylhydroxylamine, N,N-dicyclopentylhydroxylamine, N-n-hexylhydroxylamine, N,N-di-n-hexylhydroxylamine, N-isohexylhydroxylamine, N,N-diisohexylhydroxylamine, N-sec-hexylhydroxylamine, N,N-di-sec-hexylhydroxylamine, N-tert-hexylhydroxylamine, N,N-di-tert-hexylhydroxylamine, N-neohexylhydroxylamine, N,N-dineohexylhydroxylamine, N-(2-methylpentyl)hydroxylamine, N,N-bis(2-methylpentyl)hydroxylamine, N-(1,2-dimethylbutyl)hydroxylamine, N,N-bis(1,2-dimethylbutyl)hydroxylamine, N-(2,3-dimethylbutyl)hydroxylamine, N,N-bis(2,3-dimethylbutyl)hydroxylamine, N-(1-ethylbutyl)hydroxylamine, N,N-bis(1-ethylbutyl)hydroxylamine, N-cyclohexylhydroxylamine, N,N-dicyclohexylhydroxylamine, or the like. In addition, these alkylhydroxyl amines may be used alone or in combination of two or more kinds. It should be noted that as for these alkylhydroxyl amines, it is enough to use a commercial one, or the one synthesized, as appropriate, by a known method.

Among the alkylhydroxyl amines represented by the general formula [4], N-ethylhydroxylamine, N,N-diethylhydroxylamine, N-n-propylhydroxylamine are preferable. Such an alkylhydroxyl amine has particularly superior effect in view of little dissolving metal copper, as well as corrosion suppression effect of metal copper, as compared with other alkylhydroxyl amines relevant to the present invention.

The cleaning agent for a substrate having a copper wiring of the present invention is an aqueous solution and thus includes water as a composition component. Water here is not especially limited, as long as it does not give adverse influence, for example, in the cleaning process after chemical mechanical polishing (CMP), however, it is, for example, usual water, purified water such as distilled water or deionized water, ultra pure water, or the like, and among them ultra pure water is preferable. Because ultra pure water little contains impurities, it is used suitably in view of not giving adverse influence on the cleaning process.

Still more, in the cleaning agent for a substrate having a copper wiring of the present invention, in addition to the above [I], [II] and water, for example, as a pH adjuster, there may be included an acid or a base such as [III] an amine or an ammonium salt, [IV] hydrochloric acid, sulfuric acid, phosphoric acid, or any salts selected from these, within a range not to inhibit effect of the present invention. As a specific example of the [III] amine or ammonium salt here, there is included amine such as, for example, an alkanolamine such as monoethanolamine, diethanolamine, triethanolamine, monoisopropanolamine, tris(hydroxymethyl)aminomethane, 2-(morpholino)ethanol; an ammonium salt such as, for example, tetramethylammonium hydroxide, tetrapropylammonium hydroxide, tetrabutylammonium hydroxide, choline. In addition, as a specific example of the salt with hydrochloric acid, there is included, for example, tetramethylammonium chloride or the like. Further, as a specific example of the salt with sulfuric acid, there is included, for example, tetrabutylammonium hydrogen sulfate or the like. Still more, as a specific example of the salt with phosphoric acid there is included, for example, tetrabutylammonium phosphate or the like. In addition, these pH adjusters may be used alone or in combination of two or more kinds. It should be noted that as these pH adjusters, it is enough to use commercial ones.

Among the above pH adjusters, in the case where the semiconductor substrate having the copper wiring or copper alloy wiring formed with the coating film of the divalent copper and the metal corrosion inhibitor, such as Cu (II)-QCA coating film, is a cleaning object, it is preferable to use an alkanolamine such as monoethanolamine, diethanolamine, triethanolamine, monoisopropanolamine, tris(hydroxymethyl)aminomethane, or 2-(morpholino)ethanol. Such alkanolamines are preferable in view of being capable of effectively dissolving and removing, in shorter period, the divalent copper complex formed by the divalent copper and the metal corrosion inhibitor, such as Cu (II)-QCA coating film, which is a cleaning object, formed at the copper wiring surface. It should be noted that in the case where the semiconductor substrate having the copper wiring or copper alloy wiring formed with the coating film of the divalent copper and the metal corrosion inhibitor, such as Cu (II)-QCA coating film, is a cleaning object, when a phosphoric acid-type buffer agent such as disodium hydrogen phosphate, dipotassium hydrogen phosphate is used, there may the case where removal of free QCA or the Cu (II)-QCA complex becomes impossible.

It is desirable that the cleaning agent for a substrate having a copper wiring of the present invention is consisted of only the above [I], [II], [III] and water, or [I], [II], [IV] and water, in view of being capable of cleaning the substrate without giving adverse influence on the copper wiring. It should be noted that "consist of only [I], [II], [III] and water, or [I], [II], [IV] and water" means that components other than [I], [II], [III] and water, or [I], [II], [IV] and water are not included in such an amount or more that could give adverse influence on cleaning the substrate having the copper wiring, and does not mean to exclude presence of trance amount of other components. It should be noted that "consist of only [I], [II], [III] and water, or [I], [II], [IV] and water" may be also expressed as "not substantially include components other than [I], [II], [III] and water, or [I], [II], [IV] and water".

In the case where the cleaning agent for a substrate having a copper wiring of the present invention is used as an alkaline solution, it is desirable to include a base such as [III] an amine or an ammonium salt, and in the case of using the relevant alkaline solution, pH of 9 to 11 is preferable, and among them pH of 9 to 10 is more preferable. By setting pH in such a preferable range, such effects are exerted that not only being capable of effectively removing abrasive grain (polishing agent) such as silica, but also being capable of effectively dissolving and removing the divalent copper complex formed by divalent copper and the metal corrosion inhibitor, such as a Cu (II)-QCA coating film.

In the case where the cleaning agent for a substrate having a copper wiring of the present invention is used as a neutral to acidic solution, it is desirable to include an acid such as [IV] hydrochloric acid, sulfuric acid, phosphoric acid, or any salts selected these, and in the case of using in the relevant neutral to acidic solution, pH of 4 to 7 is preferable, and among them pH of 4 to 6 is more preferable. By setting pH in such a preferable range, such effects are exerted that abrasive grain (polishing agent) such as silica can be effectively removed.

Next, explanation will be given on weight % concentration of each component contained in the cleaning agent for a substrate having a copper wiring of the present invention, that is, weight % concentration of [I] the amino acids represented by the general formula [1] and the [II] alkylhydroxylamine.

Weight % concentration of [I] the amino acids represented by the general formula [1] in the cleaning agent for a substrate having a copper wiring of the present invention, in the case of using the relevant cleaning agent as an alkaline cleaning agent, is usually 0.001 to 6% by weight, and preferably 0.001 to 3% by weight, as weight % of the relevant amino acid relative to total weight of the cleaning agent. In addition, in the case of using the relevant cleaning agent as an acidic cleaning agent, is usually 0.001 to 3% by weight, and preferably 0.001 to 1 % by weight as weight % of the relevant amino acid relative to total weight of the cleaning agent. The case where use concentration of the above amino acid is below 0.001% by weight has weak action of dissolving and removing copper hydroxide (II) or copper oxide (II), which could make these remained on the substrate, while the case where use concentration is over 6% by weight as the alkaline cleaning agent, and over 3% by weight as the acidic cleaning agent has a problem of dissolution etc. of the copper wiring more than necessary. It should be noted that weight % concentration of the amino acid here means total weight % concentration of all amino acids represented by the general formula [1], in combination, and does not mean individual weight % concentration in the case where two or more kinds of the relevant amino acids are used.

Weight % concentration of the [II] alkylhydroxylamine, in the cleaning agent for a substrate having a copper wiring of the present invention, in the case of using the relevant cleaning agent as an alkaline cleaning agent, is usually 0.001 to 20% by weight, and preferably 0.001 to 15% by weight, as weight % of the relevant alkylhydroxylamine relative to total weight of the cleaning agent. In addition, in the case of using the relevant cleaning agent as an acidic cleaning agent, is usually 0.001 to 10% by weight, and preferably 0.001 to 5% by weight, as weight % of the relevant alkylhydroxylamine relative to total weight of the cleaning agent. The case where use concentration of the above alkylhydroxylamine is below 0.001% by weight makes impossible to sufficiently suppress oxidation and corrosion of the copper wiring caused by dissolved oxygen, while the case where use concentration as the alkaline cleaning agent is over 20% by weight and use concentration as the acidic cleaning agent over 10% by weight, has a problem of phase separation etc. without dissolving into water.

In addition, use concentration of the pH adjuster to be added, as appropriate, to the cleaning agent for a substrate having a copper wiring of the present invention, other than the above components of the [I] and [II], as described above, may enough to be an amount which is capable of adjusting to objective pH, and an amount within a range not to inhibit effect of the cleaning agent of the present invention, specifically, for example, weight % of a base such as [III] an amine or an ammonium salt is usually 0.002 to 10% by weight, and preferably 0.002 to 8% by weight, as weight % of the relevant base relative to total weight of the cleaning agent. In addition, for example, weight % of an acid such as the [IV] hydrochloric acid, sulfuric acid, phosphoric acid, or any salts selected from these, is usually 0.002 to 10% by weight, and preferably 0.002 to 6% by weight, as weight % of the relevant acid relative to total weight of the cleaning agent.

The method for obtaining the cleaning agent for a substrate having a copper wiring of the present invention is not especially limited, as long as it is a method for finally being able to prepare a solution including the above each component relevant to the present invention. Specifically, for example, there is included a method for making a uniform aqueous solution by directly adding and stirring the amino acids represented by the general formula [1] relevant to the present invention and alkylhydroxylamine into water, where dissolved oxygen was removed by bubbling of dry nitrogen gas, or an aqueous solution added with the pH adjuster such as, for example, tetramethylammonium hydroxide, monoisopropanolamine.

Next, explanation will be given on preferable specific example of the substrate as a cleaning object in the cleaning agent for a substrate having a copper wiring of the present invention.

In the cleaning agent for a substrate having a copper wiring of the present invention, the substrate, which is a cleaning object, is a substrate provided with at least the copper wiring or copper alloy wiring, for example, of a copper-aluminum alloy or the like. In addition, as a specific example of the substrate, which is the object, there is included, for example, a silicon (Si) substrate, a silicon carbide (SiC) substrate, a gallium arsenide (GaAs) substrate, a gallium phosphide (GaP) substrate, and an indium phosphide (InP) substrate, or the like, and among them, the silicon (Si) substrate is preferable.

In addition, in the above substrate, a barrier metal for preventing diffusion of copper to an insulator film may be included. As the relevant barrier metal, there is included specifically, for example, titanium (Ti), titanium nitride (TiN), tantalum (Ta), tantalum nitride (TaN), cobalt (Co), and ruthenium (Ru) or the like. Still more, the above substrate includes an insulator film, and as the relevant insulator film, there is included, for example, a p-TEOS thermally oxidized film, silicon nitride (SiN), nitrided silicon carbide (SiCN), a low dielectric constant film, (Low-k: SiOC, SiC) or the like.

As use form of the cleaning agent for a substrate having a copper wiring of the present invention, it is preferable to use it in the cleaning process after chemical mechanical polishing (CMP) treatment of the substrate having the copper wiring, that is, to use as the cleaning agent after Cu-CMP. When the cleaning agent for a substrate having a copper wiring of the present invention is used as the cleaning agent after the chemical mechanical polishing (CMP) process, it is capable of effectively removing not only abrasive grain (polishing agent) used in the CMP process, but also impurities derived from the copper wiring or copper alloy wiring such as copper hydroxide (II) and/or copper oxide (II) generated in the chemical mechanical polishing (CMP) process, and still more various kinds of particles.

It is preferable that the cleaning agent for a substrate having a copper wiring of the present invention is used for the semiconductor substrate having the wiring coated with, at the surface of the copper wiring or copper alloy wiring, the Cu (I)-BTA complex formed by monovalent copper and benzotriazole, or a derivative thereof, or the Cu (II)-QCA complex formed by divalent copper and quinaldic acid, or a derivative thereof, among the substrates having the copper wiring or copper alloy wiring. Usually, when the semiconductor substrate having the copper wiring or copper alloy wiring is treated with a polishing agent (for example, benzotriazole-containing SiO₂ slurry) containing benzotriazole or a derivative thereof, the surface of the copper wiring or copper alloy wiring on the substrate is coated with the monovalent copper complex formed by monovalent copper and benzotriazole or a derivative thereof, that is, the Cu (I)-BTA complex or the complex of the derivative thereof. The cleaning agent for a substrate having a copper wiring of the present invention is capable of effectively removing impurities derived from the copper wiring or copper alloy wiring, such as copper hydroxide (II) and/or copper oxide (II), without removing such the coating film of the monovalent copper complex of the copper wiring surface, such as the Cu (I)-BTA complex, at the surface of the copper wiring. That is, because the copper wiring after performing of cleaning using the cleaning agent for a substrate having a copper wiring of the present invention is coated with the monovalent copper complex such as the Cu (I)-BTA complex, such effect is obtained that corrosion prevention effect of the copper wiring or copper alloy wiring is maintained. In view of such the point, the cleaning agent for a substrate having a copper wiring of the present invention is suitable for cleaning of the semiconductor substrate having a wiring where the surface of the copper wiring or copper alloy wiring is treated with benzotriazole or a derivative thereof. On the other hand, when the semiconductor substrate having the copper wiring or copper alloy wiring is treated with a polishing agent (for example, quinaldic acid-containing SiO₂ slurry) containing quinaldic acid or a derivative thereof, the surface of the copper wiring or copper alloy wiring on the substrate is coated with the divalent copper complex formed by divalent copper and quinaldic acid or a derivative thereof, that is, the Cu (II)-QCA complex or the complex of a derivative thereof. The cleaning agent for a substrate having a copper wiring of the present invention is capable of removing such the coating film of the divalent copper complex at the surface of the copper wiring, such as the Cu (II)-QCA complex, and at the same time, effectively removing impurities derived from the copper wiring or copper alloy wiring such as copper hydroxide (II) and/or copper oxide (II). In addition to that, the copper wiring surface, after removal of the coating film of the divalent copper complex, is protected by the monovalent copper oxide such as copper oxide (I). In other words, because of formation of the copper oxide (I) as the metal corrosion protection film layer, such effect is obtained that corrosion effect of the copper wiring or copper alloy wiring is maintained. In view of such the point, the cleaning agent for a substrate having a copper wiring of the present invention is suitable for cleaning the semiconductor substrate having a wiring treated with quinaldic acid or a derivative thereof at the surface of the copper wiring or copper alloy wiring.

### - A method for cleaning a semiconductor substrate having a copper wiring of the present invention -

The method for cleaning a semiconductor substrate having a copper wiring of the present invention is characterized by using the cleaning agent for a substrate having a copper wiring consisted of an aqueous solution containing [I] the amino acid represented by the above general formula [1] and [II] the alkylhydroxylamine. That is, the method for cleaning a semiconductor substrate having a copper wiring of the present invention is characterized by using the cleaning agent for a substrate having a copper wiring of the present invention, and is not especially limited in the cleaning method itself.

As a specific example of the method for cleaning a semiconductor substrate having a copper wiring of the present invention, for example, the cleaning agent for a substrate having a copper wiring of the present invention, in which each component relevant to the cleaning agent for a substrate having a copper wiring of the present invention is prepared within a predetermined concentration range by the above preparation method, is provided. Next, by immersing the substrate, as described above, into the cleaning agent for a substrate having a copper wiring of the present invention, cleaning is attained. It should be noted that the cleaning method is not especially limited, and other than the above immersing system, there is applied a system usually being adopted in this field, such as a spinning (dropping) system, a spraying system. In addition, any of such systems may be used, as a batch system for treating a plurality of substrates at the same time, or a single wafer processing for treating one by one.

Cleaning temperature at cleaning in the method for cleaning a semiconductor substrate having a copper wiring of the present invention is not especially limited, as long as it is cleaning temperature usually being performed in this field, however, it is preferable to perform at 15 to 30°C, among them. In addition, cleaning time in cleaning is not especially limited, as long as it is cleaning time usually being performed in this field, however, it is preferable to perform cleaning for 15 to 120 seconds, in view of being capable of cleaning the substrate efficiently.

### EXAMPLES

Explanation will be given below specifically on the present invention, based on Examples and Comparative Examples, however, the present invention should not be limited to these Examples. It should be noted that % in the following Examples and Comparative Examples is weight base (w/w %) unless otherwise specified.

### Example 1 and Comparative Example 1: Immersion experiment using the cleaning agent for a substrate having a copper wiring

A wafer was purchased, which was obtained by polishing 8 inch SEMATECH 845 (copper wiring, with a barrier metal: TaN, and an oxidized film: TEOS; manufactured by SEMATECH Co., Ltd.) using polishing slurry containing benzotriazole (BTA), and then washing with pure water. The wafer was immersed into a 1 % aqueous solution of benzotriazole (BTA) for 1 hour, to form a Cu (I)-BTA coating film at the surface of the copper wiring, and after that it was rinsed with pure water using a single wafer processing-type cleaning machine (a multi-spinner, manufactured by Kaijo Corp.) and spin dried. Next the relevant substrate was cut to a small piece of about 2 cm x 2 cm to be used as an evaluation substrate.

Each 10 mL of an aqueous solution (a cleaning agent) was prepared, which is added with various kinds of complexing agents and various kinds of reducing agents shown in Table 1 and Table 2, so as to attain each 1%, and whose pH was adjusted at 9 or 6 using tetramethylammonium hydroxide (TMAH) or sulfuric acid. Next, the evaluation substrate was put into the relevant aqueous solution (the cleaning agent) and immersed for 1 hour under stirring. After that the evaluation substrate was taken out from the aqueous solution (the cleaning agent), rinsed with flowing pure water for 1 minute, dried with nitrogen gas, and then stored for 1 day in a clean room of a humidity of 50% and a temperature of 23°C, and corrosion degree at the copper wiring surface was observed using a field emission-type scanning electron microscope (FE-SEM) (S-4800, manufactured by Hitachi High-Technologies, Ltd.). Result at pH 9 is shown in Table 1, and result at pH 6 is shown in Table 2. It should be noted that the one having compositions in the bold frame in the Table corresponds to the cleaning agent for a substrate having a copper wiring of the present invention (Example 1), and others correspond to a comparative cleaning agent (Comparative Example 1). In addition, mark [-] in the Table means not performed.

**[Table 1]**

| | | Reducing agent | | | | | | | | |
|---|---|---|---|---|---|---|---|---|---|---|
| | Each 1% | DEHA | n-PrHA | None | Ascorbic acid | DHPBIS | HA | Gallic acid | Ethylene glycol | Phosphorous acid |
| Compexing agent | Sarcosine | ⊚ | Δ | × | ⊚ | × | × | × | × | × |
| | Bicine | ⊚ | ⊚ | Δ | ⊚ | × | × | × | Δ | Δ |
| | Tricine | ⊚ | ⊚ | Δ | ⊚ | × | × | × | Δ | Δ |
| | Aspartic acid | ⊚ | ⊚ | Δ | × | × | × | × | Δ | Δ |
| | Glutamic acid | ⊚ | ⊚ | Δ | ⊚ | × | × | × | Δ | Δ |
| | Citric acid | O | Δ | × | ⊚ | × | × | × | × | × |
| | Glycine | Δ | × | × | ⊚ | × | × | × | × | × |
| | Serine | × | × | × | ⊚ | × | × | × | × | × |
| | Threonine | × | × | × | ⊚ | × | × | × | × | × |
| | Arginine | × | × | × | Δ | × | × | × | × | × |
| | Ricine | × | × | × | × | × | × | × | × | × |
| | Alanine | × | × | × | Δ | × | × | × | × | × |
| | Methionine | × | × | × | ⊚ | × | × | × | × | × |
| | Proline | - | Δ | × | Δ | × | × | × | × | × |
| | Tris | Δ | - | × | ⊚ | × | × | × | × | × |
| | Bis-Tris | Δ | - | × | ⊚ | × | × | × | × | × |
| | Piperinic acid | Δ | ⊚ | Δ | ⊚ | × | × | × | Δ | Δ |
| | Acetic acid | Δ | ⊚ | Δ | ⊚ | × | × | × | Δ | Δ |
| | Ammonia | × | × | × | × | × | × | × | × | × |
| | Ethanolamine | × | × | × | Δ | × | × | × | × | × |
| | Triethanolamine | × | ⊚ | × | Δ | × | × | Δ | × | × |
| | HEDPO | × | × | × | × | × | × | × | × | Δ |
| | NONE | ⊚ | ⊚ | × | ⊚ | ⊚ | × | × | × | × |
| | ⊚: no corrosion Δ: a little corrosion ×: presence of corrosion | | | | | | | | | |
| | Sarcosine: N-methylglycine | | | | | | | | | |
| | Bicine: N,N-bis(2-hydroxyethyl)glycine | | | | | | | | | |
| | Tricine: N-[tris(hydroxymethyl)methyl]glycine | | | | | | | | | |
| | Tris: 2-amino-2-hydroxymethyl-1,3-propanediol | | | | | | | | | |
| | Bis-Tris: bis(2-hydroxyethyl)iminotris(hydroxymethyl)methane | | | | | | | | | |
| | HEDPO: 1-hydroxyethylidene-1,1-diphosphonic acid | | | | | | | | | |
| | DEHA: diethylhydroxylamine | | | | | | | | | |
| | n-PrHA: n-propylhydroxylamine | | | | | | | | | |
| | DHPBIS: 3-[(2,3-dihydroxypropyl)-hydroxyamino]-propane-1,2-diol | | | | | | | | | |
| | HA: hydroxylamine | | | | | | | | | |

**[Table 2]**

| | | Reducing agent | | | | | | | | |
|---|---|---|---|---|---|---|---|---|---|---|
| | Each 1% | DEHA | n-PrHA | None | Ascorbic acid | DHPBIS | HA | Gallic acid | Ethylene glycol | Phosphorous acid |
| Compexing agent | Sarcosine | ⊚ | Δ | × | ⊚ | × | × | × | × | × |
| | Bicine | ⊚ | ⊚ | Δ | ⊚ | × | × | × | Δ | Δ |
| | Tricine | ⊚ | ⊚ | Δ | ⊚ | × | × | × | Δ | Δ |
| | Aspartic acid | ⊚ | ⊚ | Δ | ⊚ | × | × | × | Δ | Δ |
| | Glutamic acid | ⊚ | ⊚ | Δ | ⊚ | × | × | × | Δ | Δ |
| | Citric acid | Δ | Δ | × | Δ | × | × | × | × | × |
| | Glycine | Δ | × | × | Δ | × | × | × | × | × |
| | Methionine | × | × | × | ⊚ | × | × | × | × | × |
| | Tris | ⊚ | - | Δ | ⊚ | × | - | - | - | - |
| | Piperinic acid | Δ | ⊚ | Δ | ⊚ | × | × | × | Δ | Δ |
| | Acetic acid | Δ | ⊚ | Δ | ⊚ | × | × | × | Δ | Δ |
| | Ammonia | ⊚ | - | Δ | ⊚ | × | - | - | - | - |
| | HEDPO | × | × | × | × | × | × | × | × | Δ |
| | None | ⊚ | ⊚ | × | ⊚ | ⊚ | × | × | × | × |
| | ⊚: no corrosion Δ: a little corrosion ×: presence of corrosion | | | | | | | | | |
| | Sarcosine: N-methylglycine | | | | | | | | | |
| | Bicine: N,N-bis(2-hydroxyethyl)glycine | | | | | | | | | |
| | Tricine: N-[tris(hydroxymethyl)methyl]glycine | | | | | | | | | |
| | Tris: 2-amino-2-hydroxymethyl-1,3-propanediol | | | | | | | | | |
| | HEDPO: 1-hydroxyethylidene-1,1-diphosphonic acid | | | | | | | | | |
| | DEHA: diethylhydroxylamine | | | | | | | | | |
| | n-PrHA: n-propylhydroxylamine | | | | | | | | | |
| | DHPBIS: 3-[(2,3-dihydroxypropyl)-hydroxyamino]-propane-1,2-diol | | | | | | | | | |
| | HA: hydroxylamine | | | | | | | | | |

### Example 2 and Comparative Example 2: Dissolution experiment using metal copper

A copper plate (a purity of 4N) manufactured by RARE METALLIC Co., Ltd. was cut into a small piece of about 2 cm × 2 cm, degreased by acetone cleaning, and then immersed in a 0.5 N aqueous solution of sulfuric acid for 1 hour to remove an oxide at the surface. After that it was rinsed using pure water degassed using nitrogen gas, and dried with nitrogen gas. Next relevant copper plate was, at once, put into each 10 mL of an aqueous solution (a cleaning agent) added with various kinds of complexing agents and various kinds of reducing agents shown in Table 3, so as to attain each 1%, whose pH was adjusted at 9 using tetramethylammonium hydroxide (TMAH). After the immersion for 15 minutes under stirring of the aqueous solution (the cleaning agent), the copper plate was taken out to quantitatively measure concentration of metal copper eluted into the aqueous solution (the cleaning agent), by an Inductively-Coupled Plasma Atomic Emission Spectrometer (ICP-AES), using copper oxidized to copper oxide (II) by dissolved oxygen, as an index. Result thereof is shown in Table 3. It should be noted that the one having compositions in the bold frame in the Table corresponds to the cleaning agent for a substrate having a copper wiring of the present invention (Example 2), and others correspond to a comparative cleaning agent (Comparative Example 2). In addition, mark [-] in the Table means not performed.

**[Table 3]**

| | | Reducing agent | | | | | |
|---|---|---|---|---|---|---|---|
| | Each 1% | DEHA | n-PrHA | None | Ascorbic acid | DHPBIS | HA |
| Compexing agent | Sarcosine | 1.33 | 0.3 | 5.7 | 0.8 | 1.2 | 4.7 |
| | Bicine | 0.8 | 0.2 | 3.2 | 0.2 | 0.9 | 2.5 |
| | Tricine | 0.6 | 0.2 | 1.7 | 0.2 | 0.9 | 1.4 |
| | Aspartic acid | 3.5 | 0.2 | 5.4 | 1.6 | - | - |
| | Glutamic acid | 1.51 | 0.2 | 4.8 | 1.2 | 1.48 | 2.6 |
| | Citric acid | 2.8 | 0.6 | 4.2 | 2.8 | 2.9 | 3.8 |
| | Glycine | 4 | 0.3 | 7.73 | 1.5 | 3.8 | 6.3 |
| | Ricine | 1.8 | - | 5.4 | 1.1 | - | - |
| | Methionine | 2.4 | 0.6 | 6.1 | 1.7 | - | - |
| | Tris | 1.9 | - | 6.7 | 1 | - | - |
| | Bis-Tris | 1.3 | - | 1.2 | 0.7 | - | - |
| | Ammonia | 8.7 | - | 13.8 | 2.9 | 8.4 | 6.3 |
| | Ethanolamine | - | - | 11.4 | 2.8 | - | - |
| | Sarcosine: N-methylglycine | | | | | | |
| | Bicine: N,N-bis(2-hydroxyethyl)glycine | | | | | | |
| | Tricine: N-[tris(hydroxymethyl)methyl]glycine | | | | | | |
| | Tris: 2-amino-2-hydroxymethyl-1,3-propanediol | | | | | | |
| | Bis-Tris: bis(2-hydroxyethyl)iminotris(hydroxymethyl)methane | | | | | | |
| | DEHA: diethylhydroxylamine | | | | | | |
| | n-PrHA: n-propylhydroxylamine | | | | | | |
| | DHPBIS: 3-[(2,3-dihydroxypropyl)-hydroxyamino]-propane-1,2-diol | | | | | | |
| | HA: hydroxylamine | | | | | | |

### Example 3 and Comparative Example 3: Dissolution experiment of copper oxide (II)

50 mg of copper oxide (II) powder (99.99%; produced by Wako Pure Chemical Industries, Ltd.) was weighed, and provided by putting into a 200 mL polyethylene beaker in advance. Next, 25 mL of an aqueous solution (a cleaning agent) added with various kinds of complexing agents and various kinds of reducing agents shown in Table 4, so as to attain each 1%, whose pH was adjusted at 9 using tetramethylammonium hydroxide (TMAH), was each charged into the above polyethylene beaker where 50 mg of the above copper oxide (II) powder had been weighed to dissolve the copper oxide (II) by stirring for 10 minutes. After that, undissolved copper oxide (II) was removed using a 0.2 µm filter for an aqueous system to quantitatively measure concentration of copper dissolved in the cleaning agent after the filtration, using an Inductively-Coupled Plasma Atomic Emission Spectrometer (ICP-AES), (SPS-3100HV, manufactured by SII Co., Ltd.). Result thereof is shown in Table 4. It should be noted that the one having compositions in the bold frame in the Table correspond to the cleaning agent for a substrate having a copper wiring of the present invention (Example 3), and others correspond to a comparative cleaning agent (Comparative Example 3). In addition, mark [-] in the Table means not performed.

**[Table 4]**

| | | Reducing agent | | | | | | | | |
|---|---|---|---|---|---|---|---|---|---|---|
| | Each 1% | DEHA | n-PrHA | None | Ascorbic acid | DHPBIS | HA | Gallic acid | Ethylene glycol | Phosphorous acid |
| Compexing agent | Sarcosine | 27 | 18.9 | 25 | 4.1 | 10.9 | 11.3 | 27 | 28 | 28 |
| | Bicine | 17.4 | 20.8 | 16 | 2.7 | 11.2 | 11.4 | 17.3 | 17 | 14 |
| | Tricine | 9.8 | 9.9 | 13.7 | 2.6 | 5.8 | - | - | - | - |
| | Aspartic acid | 13.5 | - | 33 | 2.4 | 10.5 | 10.4 | 11.3 | 12.5 | 13.9 |
| | Glutamic acid | 13.6 | 12.3 | 13.2 | 1.5 | 9.8 | 10.3 | 12.4 | 12.9 | 14.2 |
| | Citric acid | 3.8 | 4.4 | 3.6 | 3.7 | 3.8 | 10.8 | 3.9 | 3.9 | 4.2 |
| | Glycine | 122 | 88 | 129 | 7.1 | 102 | 107 | 148 | 134 | 121 |
| | Ricine | 24 | - | 29 | 3.5 | - | - | - | - | - |
| | Methionine | 26.9 | - | 12.5 | 2.5 | - | - | - | - | - |
| | Tris | 2.5 | - | 2.03 | 2.1 | - | - | - | - | - |
| | Bis-Tris | 2.1 | - | 3.5 | 1.2 | - | - | - | - | - |
| | Piperinic acid | 1.2 | 2 | 1.4 | 1.4 | 1.8 | 4.2 | 2.1 | 2.5 | 2 |
| | Ammonia | 60 | 62 | 64 | 63 | 62 | 60 | 63 | - | - |
| | Ethanolamine | 52 | 54 | 53 | 55 | 50 | 55 | 57 | - | - |
| | HEDPO | 7.3 | 7.2 | 7.4 | 7.7 | 7.2 | 7.7 | 7.4 | - | - |
| | Water | 0 | 0 | 0 | 0 | 0.1 | 0.3 | - | 0 | 0 |
| | Sarcosine: N-methylglycine | | | | | | | | | |
| | Bicine: N,N-bis(2-hydroxyethyl)glycine | | | | | | | | | |
| | Tricine: N-[tris(hydroxymethylimethyl]glycine | | | | | | | | | |
| | Tris: 2-amino-2-hydroxymethyl-1,3-propanediol | | | | | | | | | |
| | Bis-Tris: bis(2-hydroxyethyl)iminotris(hydroxymethyl)methane | | | | | | | | | |
| | HEDPO: 1-hydroxyethylidene-1,1-diphosphonic acid | | | | | | | | | |
| | DEHA: diethylhydroxylamine | | | | | | | | | |
| | n-PrHA: n-propylhydroxylamine | | | | | | | | | |
| | DHPBIS: 3-[(2,3-dihydroxypropyl)-hydroxyamino]-propane-1,2-diol | | | | | | | | | |
| | HA: hydroxylamine | | | | | | | | | |

### Experimental Example 1 and Comparative Example 4: Zeta potential of SiO₂ particle

Into a centrifuge tube, 1 ml of a 0.5% aqueous solution of SiO₂ was put, and various complexing agents shown in Table 5 were charged, pH thereof was adjusted using tetramethylammonium hydroxide (TMAH), as well as concentration of the complexing agent was adjusted so as to be 0.2 M, in measurement of zeta potential to prepare a solution. In the case of adding a copper ion, an aqueous solution of copper sulfate (CuSO₄) was used, and concentration of copper sulfate (CuSO₄) was also adjusted so as to be 0.2 M, in measurement of zeta potential. It should be noted that pH has surely adjusted before the measurement, so as to be pH of 9 using tetramethylammonium hydroxide (TMAH) (measurement instrument: Zetasizer µV, manufactured by Sysmex Corp.). Result thereof is shown in Table 5. It should be noted that the one having compositions in the bold frame in the Table correspond to the one containing the amino acids represented by the general formula [1], relevant to the cleaning agent for a substrate having a copper wiring of the present invention (Experimental Example 1), and others correspond to Comparative Example 4. In addition, mark [-] in the Table means not performed.

**[Table 5]**

| | SiO₂ singly | SiO₂ + Cu |
|---|---|---|
| Sarcosine | -37 | -38 |
| Aspartic acid | -40 | -36 |
| Glutamic acid | -42 | -33 |
| Tricine | - | -27 |
| Citric acid | -52 | -40 |
| Glycine | - | -42 |
| Serine | - | -36 |
| Threonine | - | -36 |
| Ricine | - | -15 |
| Arginine | - | -12 |
| Alanine | - | -37 |
| Methionine | - | -40 |
| Proline | - | -35 |
| Tris | -52 | -43 |
| Bis-Tris | - | -14 |
| Piperinic acid | - | -19 |
| Ammonia | -47 | 2.8 |
| Ethanolamine | -55 | -45 |
| Triethanolamine | -44 | -15 |
| HEDPO | -40 | -40 |
| Cysteine | - | -43 |
| Isoleucine | - | -39 |
| TMAH | -64 | -54 |
| Gallic aid | - | -33 |
| Sarcosine: N-methylglycine | | |
| Tricine: N-[tris(hydroxymethyl)methyl]glycine | | |
| Tris: 2-amino-2-hydroxymethyl-1,3-propanediol | | |
| Bis-Tris: bis(2- | | |
| HEDPO: 1-hydroxyethylidene-1,1-diphosphonic acid | | |
| TMAH: tetramethylammonium hydroxide | | |

As is clear from results of Examples 1 to 3, and Experimental Example 1 and Comparative Examples 1 to 4, only the cleaning agent for a substrate having a copper wiring of the present invention, that is, the cleaning agent for a substrate having a copper wiring of the present invention which selected the specified amino acids represented by the general formula [1] relevant to the present invention as a complexing agent, and alkylhydroxylamine as a reducing agent, has been clarified to be capable of effectively dissolving and removing copper oxide (II), without dissolving metal copper, while suppressing corrosion to the copper wiring. That is, from the result of Example 1, it has been clarified that the cleaning agent for a substrate having a copper wiring of the present invention does not corrode the copper wiring, as well as from the result of Example 2, elution of copper from the copper plate is suppressed. Still more, from the result of Example 3, it has been clarified that the cleaning agent for a substrate having a copper wiring of the present invention is capable of effectively dissolving and removing copper oxide (II). Still more, from the result of Experimental Example 1, it has been clarified that use of the amino acids represented by the general formula [1] relevant to the present invention shows minus zeta potential of SiO₂, therefore, provides the cleaning agent, which is capable of effectively removing abrasive grain (polishing agent) from the substrate, is obtained without adhering the abrasive grain (polishing agent) such as silica onto the substrate.

### Example 4 and Comparative Example 5: Dissolution experiment of a Cu (II)-quinaldic acid complex (Cu (II)-QCA complex) and free quinaldic acid (QCA)

By adding 200 µL of a 0.1 M aqueous solution of copper sulfate (CuSO₄) into 1000 µL of polishing slurry containing quinaldic acid (QCA) and potassium hydroxide, and then stirring, an aqueous solution suspended with a Cu (II)-QCA complex and free QCA was prepared. Next, by adding each of 400 µL of 0.2 M solutions of various kinds of amino acids shown in Table 6, whose pH were adjusted at 9.7 using 1000 µL of ultra pure water and tetramethylammonium hydroxide (TMAH) to the above suspension liquid, turbidity degree of the solution after the addition was confirmed visually. After that, 50 µL of an 85% aqueous solution of diethylhydroxylamine was added to each of the solutions to visually confirm turbidity degree of the solution after two minutes. Result thereof is shown in Table 6. It should be noted that compositions in the bold frame in the Table correspond to Example 4, and others correspond to Comparative Example 5.

**[Table 6]**

| | | After DEHA addition | Before DEHA addition |
|---|---|---|---|
| Amino acid | Bicine | ⊚ | ○ |
| | Tricine | ⊚ | ○ |
| | Glycine | × | × |
| | Alanine | × | × |
| | Glutamic acid | ○ | Δ |
| | ⊚: clear O: a little clear Δ: a little turbid ×: turbid | | |
| | Bicine: N,N-bis(2-hydroxyethyl)glycine | | |
| | Tricine: N-[tris(hydroxymethyl)methyl]glycine | | |
| | DEHA: diethylhydroxylamine | | |

### Example 5 and Comparative Example 6: Dissolution experiment of a Cu (II)-quinaldic acid complex (Cu (II)-QCA complex) and free quinaldic acid (QCA)

By adding 200 µL of a 0.1 M aqueous solution of copper sulfate (CuSO₄) into 1000 µL of polishing slurry containing quinaldic acid (QCA) and potassium hydroxide, and then stirring, an aqueous solution suspended with a Cu (II)-QCA complex and free QCA was prepared. Next, 400 µL of a 0.2 M solution of (A) N,N-bis(2-hydroxyethyl)glycine (Bicine) alone, or glutamic acid alone, or mixture with these two kinds of amino acids in an arbitrary ratio, or 400 µL of a 0.2 M solution of (B) N,N-bis(2-hydroxyethyl)glycine (Bicine) alone, or N-methylglycine (sarcosine) alone, or mixture with these two kinds of amino acids in an arbitrary ratio, whose pH was adjusted at 9.7 by adding 1000 µL of ultra pure water and potassium hydroxide, was each added to the above suspension liquid, and turbidity degree of the solution after the addition was confirmed visually. Result thereof is shown in Table 7. It should be noted that composition ratio and visual observation result in the bold frame in the Table correspond to Example 5, and others correspond to Comparative Example 6.

**[Table 7]**

| | | Mixing ratio of amino acid (A) | | | | | |
|---|---|---|---|---|---|---|---|
| Amino | Bicine | 10 | 8 | 6 | 4 | 2 | 0 |
| acid | Glutamic acid | ○ | 2 | 4 | 6 | 8 | 10 |
| Tubidity degree of solution | | ⊚ | ⊚ | ⊚ | ⊚ | ⊚ | ○ |
| | ⊚: clear O: a little clear Δ: a little turbid ×: turbid | | | | | | |
| | Bicine: N,N-bis(2-hydroxyethyl)glycine | | | | | | |
| | | | | | | | |

| | | mixing ratio of amino acid (B) | | | | | |
|---|---|---|---|---|---|---|---|
| Amino | Bicine | 10 | 8 | 6 | 4 | 2 | 0 |
| acid | Sarcosine | 0 | 2 | 4 | 6 | 8 | 10 |
| Tubidity degree of solution | | ⊚ | ⊚ | ⊚ | ⊚ | ⊚ | ○ |
| | ⊚: clean O: a little clear Δ: a little turbid × : turbid | | | | | | |
| | Bicine: N,N-bis(2-hydroxyethyl)glycine | | | | | | |
| | sarcosine: N-methylglycine | | | | | | |

As is clear from results of Example 4 and Comparative Example 5, in the case where the cleaning agent for a substrate having a copper wiring of the present invention is used for cleaning of the semiconductor substrate having the copper wiring coated with a Cu (II)-QCA complex formed by divalent copper and quinaldic acid or a derivative thereof, it has been clarified that it is desirable to use an amino acid including at least any one kind of N,N-bis(2-hydroxyethyl)glycine (Bicine) and N-[tris(hydroxymethyl)methyl]glycine (Tricine) among the amino acids represented by the general formula [1] relevant to the present invention. That is, in order to remove the Cu (II)-QCA complex on the copper wiring surface, it is necessary to dissolve the Cu (II)-QCA complex formed on the copper wiring surface, however, from the results of Example 4 and Comparative Example 5, it has been clarified that, in the case of using glycine or alanine not corresponding to the amino acids represented by the general formula [1] relevant to the present invention, the Cu (II)-QCA complex formed on the copper wiring surface cannot be removed by these cleaning agents, due to being nearly impossible to dissolve the Cu (II)-QCA complex and free QCA, irrespective of presence or absence of the addition of hydroxylamine. On the other hand, it has been clarified that these cleaning agents are capable of effectively removing the Cu (II)-QCA complex formed on the copper wiring surface, due to complete dissolution of the Cu (II)-QCA complex and free QCA, after the addition of hydroxylamine, when Bicine or Tricine is used.

As is clear from results of Example 5 and Comparative Example 6, it has been clarified that a mixture of either of Bicine and Tricine with other amino acids is superior in dissolution and removal capability of the Cu (II)-QCA complex and free QCA, as compared with glutamic acid alone, or sarcosine alone. In addition, it has been clarified that the case of mixing either of Bicine and Tricine with other amino acids is equivalent or superior in elution and removal capability of the Cu (II)-QCA complex and free QCA, as compared with Bicine alone or Tricine alone, by adjusting weight ratio thereof. From this fact, it has also been clarified desirable to use at least either of Bicine and Tricine, among the amino acids represented by the general formula [1] relevant to the present invention, as a component of the cleaning agent, in dissolution and removal of the Cu (II)-QCA complex and free QCA.

Examples 6 to 8 and Comparative Example 7: Dissolution experiment over time of a Cu (II)-quinaldic acid complex (Cu (II)-QCA complex) and free quinaldic acid (QCA)
By adding 40 µL of a 0.1 M aqueous solution of copper sulfate (CuSO₄) into 200 µL of polishing slurry containing quinaldic acid (QCA) and potassium hydroxide, and then stirring, an aqueous solution suspended with a Cu (II)-QCA complex and free QCA was prepared. Next, by adding each 1000µL of the solution, which is 30 times dilution of each cleaning agent having composition ratio shown in Table 8, to the above suspension liquid, time course of turbidity degree of the solution from just after the addition was confirmed visually. Result thereof is shown in Table 8.

**[Table 8]**

| | Example 6 | Example 7 | Example 8 | Comparative Example 7 |
|---|---|---|---|---|
| Compexing agent (Amino acid) | Bicine 2.1% | Bicine 0.7% | Bicine 2.8% | Glutamic acid 3% |
| | Glutamic acid 1.27% | Glutamic acid 0.3% | Glutamic acid 0.3% | |
| Reducing agent | Diethylhydroxylamine 12% | Diethylhydroxylamine 12% | Diethylhydroxylamine 12% | Diethyl hyd roxyla mine 12% |
| Alkali component | TMAH 2.3% | mono-Isopropanolamine 6% | mono-Isopropanolamine 3% | TMAH 2.3% |
| pH | 9.7 | 10 | 9.8 | 9.9 |
| Turbidity degree after 20 sec. | Δ | ⊚ | ⊚ | × |
| Turbidity degree after 60 sec. | ○ | ⊚ | ⊚ | × |
| Turbidity degree after 120 sec. | ⊚ | ⊚ | ⊚ | Δ |
| | ⊚: clean O: a little clear Δ: a little turbid ×: turbid | | | |
| | Bicine: N,N-bis(2-hydroxyethyl)glycine | | | |
| | TMAH: tetramethylhydroxylamine | | | |

### Examples 9 to 11; Immersion experiment using the cleaning agent for a substrate having a copper wiring

A wafer was purchased, which was obtained by polishing 8 inch SEMATECH 845 (copper wiring, with a barrier metal: TaN, and an oxidized film: TEOS; manufactured by SEMATECH Co., Ltd.) using polishing slurry containing benzotriazole (BTA), and then washing with pure water. The wafer was rinsed with methanol (MeOH), and after that immersed into an isopropanol (IPA) solution for 30 seconds, and still more rinsed with pure water for 10 seconds. Next the wafer after rinse was immersed in a 0.1 M aqueous solution of dilute sulfuric acid for 30 seconds, rinsed with flowing pure water and washed with isopropanol (IPA) sequentially in this order, and then dried with nitrogen gas. The wafer was immersed in 1% quinaldic acid (QCA) containing slurry, which includes a 0.07% aqueous solution of hydrogen peroxide, for 30 seconds, to form a Cu (II)-QCA coating film on the surface of the copper wiring, and after that it was rinsed with pure water using a single wafer processing-type cleaning machine (a multi-spinner, manufactured by Kaijo Corp.) and spin dried. Next the relevant substrate was cut to a small piece of about 2 cm × 2 cm to be used as an evaluation substrate.

Each 15 mL of 30 times diluted aqueous solution (a cleaning agent) of each cleaning agent having composition ratio shown in Table 9, was prepared. Next, into the relevant aqueous solution (the cleaning agent), the evaluation substrate was put and immersed for predetermined period of time under stirring. After that, the evaluation substrate was taken out from the aqueous solution (the cleaning agent), rinsed with flowing pure water for 1 minute, dried with nitrogen gas, and then stored for 1 day in a clean room of a humidity of 50% and a temperature of 23°C, and corrosion degree at the copper wiring surface was observed using a field emission-type scanning electron microscope (FE-SEM) (S-4800, manufactured by Hitachi High-Technologies, Ltd.). Result thereof is shown in Table 9. In addition, at the same time, the copper wiring surface was measured using an X-ray Photoelectron Spectroscopy (XPS) (AXIS-His, manufactured by Kratos Co., Ltd.), to confirm that the copper wiring surface was converted to copper oxide (I) (Cu₂O).

**[Table 9]**

| | Example 9 | Example 10 | Example 11 |
|---|---|---|---|
| Compexing agent (Amino acid) | Bicine 2.1% | Bicine 0.7% | Bicine 2.8% |
| | Glutamic acid 1.27% | Glutamic acid 0.3% | Glutamic acid 0.3% |
| Reducing agent | Diethylhydroxylamine 12% | Diethylhydroxylamine 12% | Diethylhydroxylamine 12% |
| Alkali component | TMAH 2.3% | mono-isopropanolamine 6% | mono-isopropanolamine 3% |
| pH | 9.7 | 10 | 9.8 |
| Immersion for 1 minute | ⊚ | ⊚ | ⊚ |
| Immersion for 3 minutes | ⊚ | ⊚ | ⊚ |
| Immersion for 5 minutes | ⊚ | ⊚ | ⊚ |
| | ⊚: no corrosion Δ: a little corrosion ×: presence of corrosion | | |
| | Bicine: N,N-bis(2-hydroxyethyl)glycine | | |
| | TMAH: tetramethylhydroxylamine | | |

As is clear from results of Examples 6 to 11 and Comparative Example 7, in the case where the cleaning agent for a substrate having a copper wiring of the present invention is used for cleaning of the semiconductor substrate having the copper wiring coated with a Cu (II)-QCA complex formed by divalent copper and quinaldic acid or a derivative thereof, it has been clarified that an alkanol amine such as monoisopropanol amine can dissolve and remove the Cu (II)-QCA complex in shorter period as compared with an alkylammonium salt such as tetramethylammonium hydroxide (TMAH), as a base to adjust pH to an alkaline state. That is, it has been clarified that an alkanol amine, which is an organic solvent-type basic substance, is more preferable as compared with an alkylammonium salt, which is a water soluble basic substance, to effectively dissolve and remove quinaldic acid, which is an acidic organic substance. From these results, it has been clarified that the cleaning agent for a substrate having a copper wiring of the present invention added with an alkanol amine as a base is capable of treating a plurality of the semiconductor substrates having the Cu (II)-QCA coating film at the copper wiring surface, in shorter period, without giving adverse influence on the copper wiring.

As is clear from the above results, it has been clarified that the cleaning agent for a substrate having a copper wiring of the present invention is a superior cleaning agent which is capable of effectively removing impurities such as copper hydroxide (II), copper oxide (II) and the like, generated at the chemical mechanical polishing (CMP) process, and abrasive grain (polishing agent) such as silica used in the CMP process, without giving adverse influence on the copper wiring. In addition, it has been clarified that the cleaning agent for a substrate having a copper wiring of the present invention is a suitable cleaning agent for cleaning the semiconductor substrate having the copper wiring or copper alloy wiring formed with such a metal corrosion inhibition film layer, because of being capable of removing a coating film (the metal corrosion inhibition film layer) of divalent copper and the metal corrosion inhibitor, such as the Cu (II)-QCA coating film, while not giving adverse influence on the coating film (the metal corrosion inhibition film layer) of monovalent copper and the metal corrosion inhibitor, such as the Cu (I)-BTA coating film.

### INDUSTRIAL APPLICABILITY

The cleaning agent for a substrate having a copper wiring of the present invention is the one which can be used as the cleaning agent for the semiconductor substrate having the copper wiring or copper alloy wiring, after the chemical mechanical polishing (CMP) process, that is, the cleaning agent after Cu-CMP, and particular, the cleaning agent suitable for the semiconductor substrate having the copper wiring or copper alloy wiring formed with the metal corrosion inhibition film layer at the surface thereof.

The method for cleaning a semiconductor substrate having a copper wiring of the present invention is an effective method for cleaning of the semiconductor substrate etc. provided with the copper wiring or copper alloy wiring, for example, after the chemical mechanical polishing (CMP) process, and is, in particular, a suitable method for cleaning of the semiconductor substrate having the copper wiring or copper alloy wiring formed with the metal corrosion inhibition film layer at the surface thereof.

## Claims

1. A cleaning agent for a substrate having a copper wiring consisting of an aqueous solution comprising [I] an amino acid represented by the following general formula [1], and [II] an alkylhydroxylamine; 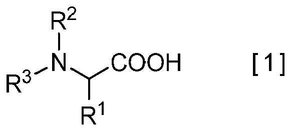 (wherein R¹ represents a hydrogen atom, a carboxymethyl group or a carboxyethyl group; and R² and R³ each independently represents a hydrogen atom or an alkyl group having 1 to 4 carbon atoms, which may have a hydroxyl group, provided that those where R¹ to R³ are all hydrogen atoms are excluded.).

2. The cleaning agent according to claim 1, wherein the copper wiring is the one coated with a Cu (I)-benzotriazole complex formed by monovalent copper and benzotriazole or a derivative thereof.

3. The cleaning agent according to claim 1, wherein the copper wiring is the one coated with a Cu (II)-quinaldic acid complex formed by divalent copper and quinaldic acid or a derivative thereof.

4. The cleaning agent according to claim 1, wherein the substrate is the one after chemical mechanical polishing (CMP).

5. The cleaning agent according to claim 2, wherein the cleaning agent is for removing at least either of copper hydroxide (II) and copper oxide (II).

6. The cleaning agent according to claim 3, wherein the cleaning agent is for removing a copper (II)-quinaldic acid complex, and at least either of copper hydroxide (II) and copper oxide (II).

7. The cleaning agent according to claim 1, wherein pH of the aqueous solution is in a range of 9 to 11.

8. The cleaning agent according to claim 1, wherein pH of the aqueous solution is in a range of 4 to 7.

9. The cleaning agent according to claim 1, wherein the aqueous solution is a solution further comprising [III] an amine or an ammonium salt.

10. The cleaning agent according to claim 1, wherein the aqueous solution is a solution further comprising [IV] a hydrochloric acid, a sulfuric acid, a phosphoric acid, or any salts selected from these.

11. The cleaning agent according to claim 9, wherein the aqueous solution is a solution consisting of only the [I], [II], [III] and water.

12. The cleaning agent according to claim 10, wherein the aqueous solution is a solution consisting of only the [I], [II], [IV] and water.

13. The cleaning agent according to claim 9, wherein % by weight of [I] the amino acid represented by the general formula [1], is 0.001 to 6% by weight, % by weight of the [II] alkylhydroxylamine is 0.001 to 20% by weight, and % by weight of the [III] amine or ammonium salt is 0.002 to 10% by weight.

14. The cleaning agent according to claim 10, wherein % by weight of [I] the amino acid represented by the general formula [1], is 0.001 to 3% by weight, % by weight of the [II] alkylhydroxylamine is 0.001 to 10% by weight, and % by weight of the [IV] hydrochloric acid, sulfuric acid, phosphoric acid, or any salts selected from these is 0.002 to 10% by weight, and the copper wiring is the one coated with a Cu (I)-benzotriazole complex formed by monovalent copper and benzotriazole or a derivative thereof.

15. The cleaning agent according to claim 2, wherein [I] the amino acid represented by the general formula [1] is the one represented by the following general formula [2] or the following general formula [3]; 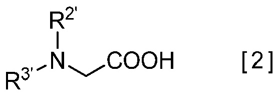 (wherein R^{2'} and R^{3'} each independently represents a hydrogen atom or an alkyl group having 1 to 4 carbon atoms, which may have a hydroxyl group, provided that those where R^{2'} and R^{3'} are all hydrogen atoms are excluded.), 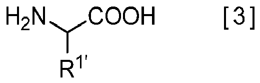 (wherein R^{1'} represents a carboxymethyl group or a carboxyethyl group.).

16. The cleaning agent according to claim 2, wherein [I] the amino acid represented by the general formula [1] is the one selected from N-methylglycine, N,N-bis(2-hydroxyethyl)glycine, N-[tris(hydroxymethyl)methyl]glycine, aspartic acid and glutamic acid.

17. The cleaning agent according to claim 3, wherein one kind of [I] the amino acids represented by the general formula [1] is the one selected from N,N-bis(2-hydroxyethyl)glycine and N-[tris(hydroxymethyl)methyl]glycine.

18. The cleaning agent according to claim 1, wherein the [II] alkylhydroxylamine is the one represented by the following general formula [4]; 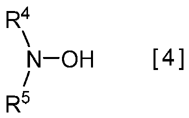 (wherein R⁴ represents an alkyl group having 1 to 6 carbon atoms, and R⁵ represents a hydrogen atom or an alkyl group having 1 to 6 carbon atoms.).

19. The cleaning agent according to claim 1, wherein the [II] alkylhydroxylamine is the one selected from N-ethylhydroxylamine, N,N-diethylhydroxylamine and N-n-propylhydroxylamine.

20. The cleaning agent according to claim 9, wherein the [III] amine or ammonium salt is the one selected from monoethanolamine, diethanolamine, triethanolamine, monoisopropanolamine, tris(hydroxymethyl)aminomethane, 2-(morpholino)ethanol, tetramethylammonium hydroxide and choline.

21. A method for cleaning a semiconductor substrate having a copper wiring, **characterized by** using the cleaning agent according to claim 1.

22. The method according to claim 21, wherein the semiconductor substrate having a copper wiring is the one treated with an aqueous solution containing benzotriazole or a derivative thereof.

23. The method according to claim 21, wherein the semiconductor substrate having a copper wiring is the one treated with an aqueous solution containing quinaldic acid or a derivative thereof.

24. The method according to claim 21, wherein the semiconductor substrate having a copper wiring is the one after chemical mechanical polishing (CMP).

25. The method according to claim 22, wherein the method is for removing at least either of copper hydroxide (II) and copper oxide (II).

26. The method according to claim 23, wherein the method is for removing a copper (II)-quinaldic acid complex, and at least either of copper hydroxide (II) and copper oxide (II).

27. The method according to claim 21, wherein the cleaning is performed at 15 to 30°C.
